# EUROPEAN PATENT SPECIFICATION

(11) **EP 3 442 208 B1**
(45) Date of publication and mention of the grant of the patent: **14.10.2020**
(21) Application number: 17788691.8
(22) Date of filing: 19.04.2017
(51) Int. Cl.: H04M 1/18, H05K 5/06, G06K 13/08

(54) **SHELL OF USER TERMINAL, AND USER TERMINAL**
SCHALE EINES BENUTZERENDGERÄTS UND BENUTZERENDGERÄT
COQUE DE TERMINAL UTILISATEUR ET TERMINAL UTILISATEUR

(30) Priority: 29.04.2016 CN 201620384187 U
(43) Date of publication of application: 13.02.2019
(73) Proprietor: Huawei Technologies Co., Ltd., Longgang District Shenzhen, Guangdong 518129 (CN)
(72) Inventor: GAO, Jiuliang, Shenzhen Guangdong 518129 (CN); LI, Ruifeng, Shenzhen Guangdong 518129 (CN); LI, Guanglong, Shenzhen Guangdong 518129 (CN)
(74) Representative: Maiwald Patent- und Rechtsanwaltsgesellschaft mbH
(86) International application number: PCT/CN2017/081109
(87) International publication number: WO 2017/186039

(56) References cited:
- CN-A- 105 263 288
- CN-A- 105 357 346
- CN-U- 205 122 879
- CN-U- 205 754 497
- US-A1- 2003 117 788
- US-A1- 2011 252 609
- US-A1- 2013 025 932
- US-A1- 2014 231 132

## Description

### TECHNICAL FIELD

The present invention relates to the field of user terminals, and more specifically, to a handset comprising a housing.

### BACKGROUND

Currently, a card tray of a user terminal is usually designed in a pop-up manner, and force needs to be applied to the card tray to pop up. At present, because an internal structure of the user terminal is becoming increasingly compact, and the handset has limited space and cannot provide relatively large space for pressing, in a general design, an ejector pin with a relatively small diameter is used to complete pressing action. For the ejector pin, an opening needs to be disposed on a shell element, so as to facilitate insertion of the ejector pin. The opening causes a decrease in a water-proof capability of the handset, and therefore, water-proof protection is required for the handset. At present, a general design in the industry is sealing a periphery of a card connector of the handset, so as to resolve a water entry problem of a pinhole.

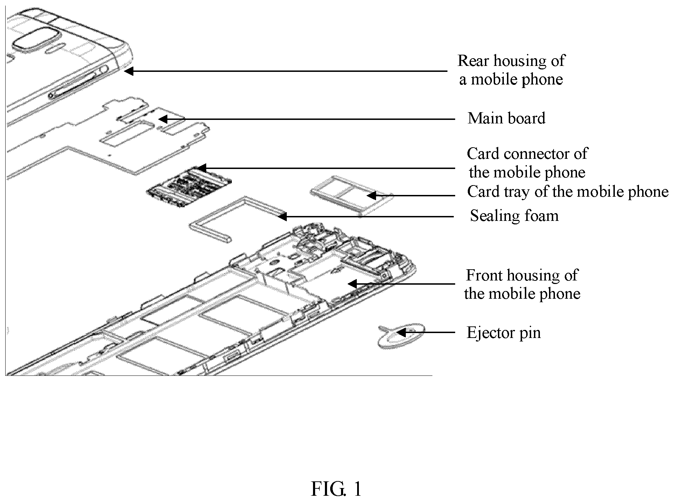

FIG. 1 shows a card connector sealing manner in the prior art. A prior-art solution is designing a retaining wall for a periphery of the card connector of the handset adjacent to a front housing of the handset, and adhering sealing foam to the retaining wall, so as to cover a main board and enclose the card connector of the handset. When water enters a pinhole, on a rear housing of the handset, for yielding to the ejector pin, the water does not enter the handset, so as to implement a water-proof effect. However, in the solution, the retaining wall and foam need to be increased, thereby occupying large space and causing relatively high costs.

CN 205 122 879 U discloses a smart mobile phone comprises a housing, a card tray. There are two water-proof structures on the smart mobile phone. The first water-proof structures comprises a first water-proof groove and a first water-proof ring to implement a water-proof effect between the card tray and the housing. The second water-proof structures comprises a second water-proof groove set on a bar and a second water-proof ring set in the second water-proof groove, both the bar and the second water-proof ring are set in the housing to implement a water-proof effect for the pinhole of the housing.

US 2011/0252609 A1 discloses a cord management system includes a case and a strap. The strap has a first attachment point at a first location on the strap and a second attachment point a second location on the strap. The strap also includes at least two modes of operation. In a first mode of operation, the first attachment point is attached to the second attachment point so that a first segment of the strap located between the first attachment point and the second attachment point forms a loop configured to secure a cord that is wrapped around the case. In a second mode of operation, the first attachment point is detached from the second attachment point so that the first segment no longer forms the loop. The strap comprises a cord-attachment mechanism for allowing the magnetic strap to be attached to a cord (and/or a connector for the cord). The cord-attachment mechanism has a single slit or a plurality of slits. When a cord is inserted into the slits, the material around the respective slits applies a pressure against the cord and hold the cord to the magnetic strap.

### SUMMARY

In view of this, this application provides a handset comprising a housing, so as to resolve a large space occupancy problem and a high cost problem that are caused because a long retaining wall and sealing foam are disposed at a periphery of a card connector to enclose the card connector for waterproofing.

According to a first aspect, a handset is provided, where the handset includes a housing, a card tray, the card tray is configured to be inserted to or detached from the handset, wherein a pinhole is disposed on the housing, the card tray is detached from the handset after an ejector pin passes through the pinhole and a sealing kit and a force is applied on the ejector pin; the sealing kit is inside the handset; an opening is disposed on the sealing kit; when the ejector pin passes through the sealing kit after passing through the pinhole, the opening on the sealing kit is opened; and when the ejector pin is unplugged from the sealing kit, the opening on the sealing kit is closed for water proofing.

In this way, the sealing kit is disposed at the pinhole for detaching the card tray of the handset, so as to implement sealing at the pinhole with low costs and small space occupancy, implement a water-proof effect, and resolve the large space occupancy problem and the high cost problem in the prior art that are caused because the long retaining wall and the sealing foam are disposed at the periphery of the card connector to enclose the card connector for waterproofing.

Optionally, the sealing kit is disposed at the pinhole and is inside the housing.

Optionally, the opening is located on a position corresponding to the pinhole's position.

Optionally, the opening is located on a position corresponding to the middle of the pinhole.

Optionally, the housing is a front housing.

Optionally, the housing is a rear housing.

Optionally, the housing comprises a frame, the pinhole is located on the frame.

Optionally, the sealing kit is a rubber pad. The rubber pad is pasted on an inner side of the housing.

It should be understood that, the sealing kit includes but is not limited to the rubber pad, that is, a material of the sealing kit is not limited to rubber. Any other elastic and water-proof material may be used as the material of the sealing kit in this embodiment of the present invention.

Optionally, the opening disposed on the sealing kit is a cross-shaped gap.

It should be understood that, the opening disposed on the sealing kit includes but is not limited to the cross-shaped gap, and may be a gap in another form, for example, a line-shaped gap, a gap in a shape of " 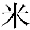 ", or the like. This is not limited in the present invention.

### BRIEF DESCRIPTION OF DRAWINGS

To describe the technical solutions in the embodiments of the present invention more clearly, the following briefly describes the accompanying drawings required for describing the embodiments of the present invention. Apparently, the accompanying drawings in the following description show merely some embodiments of the present invention, and a person of ordinary skill in the art may still derive other drawings from these accompanying drawings without creative efforts.
FIG. 1 is a schematic diagram of a card connector sealing manner in the prior art;
FIG. 2 is a schematic exploded view of a handset in three dimensions according to an embodiment of the present invention;
FIG. 3 is a schematic diagram of a pinhole that is on a housing of a handset and that is configured to detach a card tray of the handset according to an embodiment of the present invention;
FIG. 4 is a schematic diagram of a housing when an ejector pin is inserted into the housing of a handset according to an embodiment of the present invention; and
FIG. 5 is a schematic diagram of a housing when an ejector pin is unplugged from the housing of a handset according to an embodiment of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are a part rather than all of the embodiments of the present invention. All other embodiments obtained by a person of ordinary skill in the art based on the embodiments of the present invention without creative efforts shall fall within the protection scope of the present invention.

It should be understood that, a user terminal (Mobile Terminal) in the embodiments of the present invention includes but is not limited to a mobile station (Mobile Station, "MS" for short), a mobile phone (Mobile Telephone), a handset (handset), a tablet computer, a portable device (portable equipment), or the like.

An embodiment of the present invention provides a housing of a user terminal. A jack is disposed on the housing. A sealing kit is disposed at the jack and is inside the housing. An opening is disposed on the sealing kit. The opening is located in the middle of the jack. When a pin passes through the sealing kit after passing through the jack, the opening on the sealing kit is opened. When the pin is unplugged from the sealing kit, the opening on the sealing kit is closed.

In another embodiment, the jack is a pinhole configured to detach a card tray of the user terminal, and the pin is an ejector pin configured to detach the card tray of the user terminal.

In another embodiment, the jack is an earphone jack, and the pin is an earphone connector.

In another embodiment, the jack is a Universal Serial Bus (Universal Serial Bus, "USB" for short) port, and the pin is a USB connector.

In the prior art, for waterproofing, a long retaining wall and sealing foam are disposed around a card connector to enclose the card connector, and an area of the card connector is relatively large. As a result, the long retaining wall and the sealing foam around the card connector occupy a lot of space and lead to high costs. However, in this embodiment of the present invention, the sealing kit is disposed at the pinhole for detaching the card tray of the user terminal. Because the pinhole is small, the sealing kit is also relatively small, thereby implementing sealing at the pinhole with low costs and small space occupancy, and implementing a water-proof effect.

In addition, for the earphone jack, a USB port, and another jack on the housing of the user terminal, the sealing kit may also be disposed, so as to implement water-proof sealing for the earphone jack, the USB port, and the another jack.

It should be noted that, in this embodiment of the present invention, the sealing kit described above may be disposed at any other opening that is included on the housing of the user terminal and into which a connector can be inserted. This is not limited in the present invention.

In another embodiment, the sealing kit is a rubber pad.

It should be understood that, the sealing kit includes but is not limited to the rubber pad, that is, a material of the sealing kit is not limited to rubber. Any other elastic and water-proof material may be used as the material of the sealing kit in this embodiment of the present invention.

In another embodiment, the opening disposed on the sealing kit is a cross-shaped gap.

When no force is applied, the cross-shaped gap is in a closed state. When external force is applied, the cross-shaped gap may be opened. When the external force disappears, the cross-shaped gap may regain the original closed state.

It should be understood that, the opening disposed on the sealing kit includes but is not limited to the cross-shaped gap, and may be a gap in another form, for example, a line-shaped gap, a gap in a shape of " 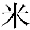 ", or the like. This is not limited in the present invention, provided that the gap is too small to allow water to enter.

In another embodiment, the user terminal is a handset.

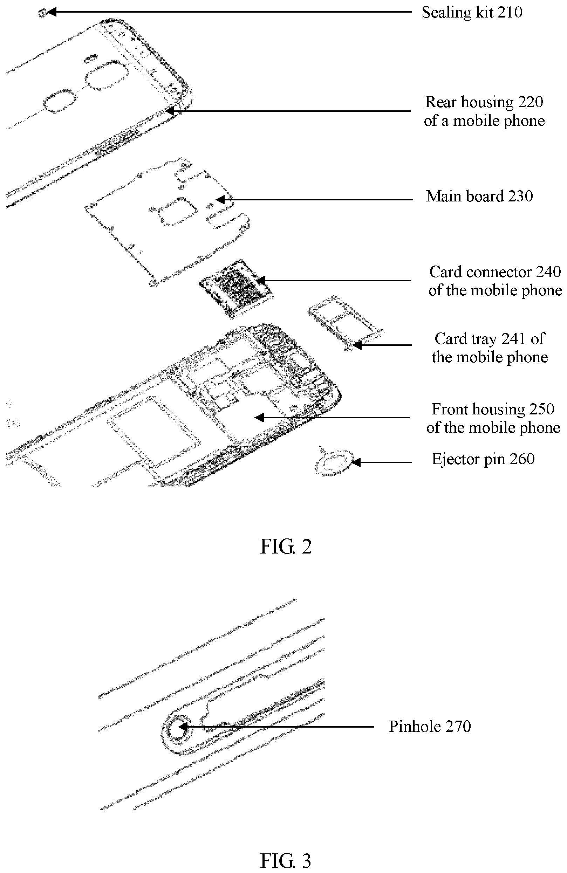

The following describes in detail the housing of the user terminal in this embodiment of the present invention with reference to FIG. 2 to FIG. 5. Herein, sealing kit at the pinhole that is on the housing of the handset and that is configured to detach the card tray of the handset is used as an example for description.

Specifically, FIG. 2 is a schematic exploded view of a handset in three dimensions according to an embodiment of the present invention. The handset shown in FIG. 2 includes a sealing kit 210, a rear housing 220 and a front housing 250 of the handset, a main board 230, a card connector 240 of the handset, a card tray 241 of the handset, and an ejector pin 260. The rear housing 220 and the front housing 250 of the handset may be collectively referred to as the housing of the handset. The card tray 241 of the handset is configured to accommodate a storage card, for example, a subscriber identity module (Subscriber Identity Module, "SIM" for short) card or a trans flash (Trans Flash, "TF" for short) card. When the card tray 241 of the handset is inserted into the handset by applying external force to the card tray 241 of the handset, the storage card and the card connector 240 of the handset can be electrically connected. FIG. 3 is a schematic diagram of a pinhole that is on an outer side of a housing of a handset and that is configured to detach a card tray of the handset according to an embodiment of the present invention. FIG. 3 shows a pinhole 270 configured to detach the card tray of the handset. When the ejector pin 260 is inserted into the pinhole 270 and specific force is applied to the ejector pin, the card tray 241 of the handset can pop up, so as to conveniently take out the storage card.

The sealing kit 210 shown in FIG. 2 may be disposed and is inside the rear housing 220 of the handset. The sealing kit 210 may be a rubber pad 211. An opening disposed on the rubber pad 211 may be a cross-shaped gap.

It should be understood that, if the pinhole configured to detach the card tray 241 of the handset is located on the front housing 250 of the handset, the sealing kit 210 is disposed at the pinhole and is inside the front housing 250 of the handset; or if the housing of the handset further includes a frame and the pinhole configured to detach the card tray 241 of the handset is located on the frame, the sealing kit 210 is disposed at the pinhole and is inside the frame.

For example, it is assumed that a thickness of the rear housing 220 of the handset is 0.55 mm, the pinhole 270 that is disposed on the rear housing 220 of the handset and that is configured to detach the card tray 241 of the handset is a circle, a thickness of the pinhole 270 is the same as a thickness of the rear housing 220 of the handset, and a diameter of the pinhole 270 is 1.2 mm. The rubber pad 211 disposed at the pinhole 270 may be fastened on the inner side of the rear housing 220 of the handset in a paste manner, or may be fastened on the rear housing 220 in another manner. This is not limited in the present invention. A shape of the rubber pad 221 may be a square shown in FIG. 3. A size of the rubber pad 221 may be set to 2.5 mm × 2.5 mm × 0.3 mm, that is, both a length and a width of the rubber pad are set to 2.5 mm, and a thickness is set to 0.3 mm. An opening on the rubber pad is a cross-shaped gap, and the cross-shaped gap is located in the center of the pinhole 270. A size of the cross-shaped gap may be 1.2 mm × 1.2 mm, that is, both gap lengths on a horizontal direction and a vertical direction of the "cross" are 1.2 mm.

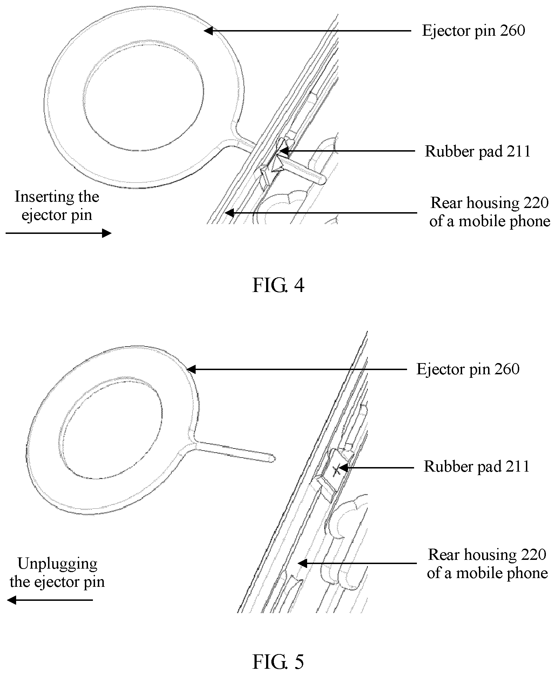

Specifically, details are described with reference to FIG. 4 and FIG. 5. FIG. 4 and FIG. 5 separately show the ejector pin 260 configured to detach the card tray 241 of the handset, the rubber pad 211, and the rear housing 220 of the handset. An area of the sealing kit 210 is larger than an area of the pinhole. As shown in FIG. 4, FIG. 4 is a schematic diagram of an inner side of a housing of a handset when the ejector pin is inserted according to an embodiment of the present invention. The rubber pad 211 is pasted at the pinhole 270 on the rear housing 220 of the handset, and the cross-shaped gap is disposed on the rubber pad 211. Therefore, when the ejector pin 260 configured to detach the card tray 241 of the handset is inserted into the rubber pad 211 after passing through the pinhole 270, because the rubber pad 211 is elastic, the rubber pad 211 is deformed and opened at the cross-shaped gap under external force. As shown in FIG. 5, FIG. 5 is a schematic diagram of the inner side of the housing of the handset when the ejector pin is unplugged according to an embodiment of the present invention. When the ejector pin 260 configured to detach the card tray 241 of the handset is unplugged from the rubber pad 211, because the rubber pad 211 is elastic, as force disappears, the rubber pad 211 can be automatically closed at the cross-shaped gap, and regain a shape before insertion, so as to implement a water-proof effect.

Therefore, the sealing kit is disposed at the pinhole configured to detach the card tray of the user terminal, so as to implement sealing at the pinhole and the water-proof effect. In addition, a long retaining wall and sealing foam do not need to be disposed on the front housing of the handset to enclose the card connector. Therefore, a layout area of the main board is increased, internal space of the housing of the handset is saved, and costs are reduced.

If an earphone jack is disposed on the housing of the user terminal, a sealing kit is disposed at the earphone jack, for example, a rubber pad, and a cross-shaped gap is disposed on the rubber pad. In this case, when an earphone connector is inserted into the rubber pad after passing through the earphone jack, because the rubber pad is elastic, the rubber pad is deformed and opened at the cross-shaped gap; and when the earphone connector is unplugged from the rubber pad, the rubber pad can be automatically closed at the cross-shaped gap, and regain the shape before insertion, so as to implement the water-proof effect.

In this way, the sealing kit is disposed at the earphone jack of the user terminal, so as to implement sealing at the earphone jack, and implement the water-proof effect. In addition, advantages of small space occupancy and low costs are obtained.

Similarly, if a USB port is disposed on the housing of the user terminal, a sealing kit is disposed at the USB port, for example, a rubber pad, and a cross-shaped gap is disposed on the rubber pad. In this case, when a USB connector is inserted into the rubber pad after passing through the USB port, because the rubber pad is elastic, the rubber pad is deformed and opened at the cross-shaped gap; and when the USB connector is unplugged from the rubber pad, the rubber pad can be automatically closed at the cross-shaped gap, and regain the shape before insertion, so as to implement the water-proof effect.

In this way, the sealing kit is disposed at the USB port of the user terminal, so as to implement sealing at the USB port, and implement the water-proof effect. In addition, advantages of small space occupancy and low costs are obtained.

It should be understood that, for another user terminal, for example, a tablet computer and another portable device, any jack such as a pinhole, an earphone jack, or a USB port on the housing of the handset may be sealed in the sealing manner shown in FIG. 4 and FIG. 5. For brevity, details are not described herein.

It should be noted that, the foregoing application is merely an example for description. In practice, an application scenario of the sealing manner used in the housing of the user terminal may be set according to a requirement. This is not specifically limited in this embodiment of the present invention.

This embodiment of the present invention further provides a user terminal. The user terminal includes the housing described above. A jack is disposed on the housing. A sealing kit is disposed at the jack and is inside the housing. An opening is disposed on the sealing kit. The opening is located in the middle of the jack. When a pin passes through the sealing kit after passing through the jack, the opening on the sealing kit is opened. When the pin is unplugged from the sealing kit, the opening on the sealing kit is closed.

The units described as separate parts may or may not be physically separate, and parts displayed as units may or may not be physical units, may be located in one position, or may be distributed on a plurality of network units. Some or all of the units may be selected according to actual requirements to achieve the objectives of the solutions of the embodiments.

The foregoing descriptions are merely specific implementations of the present invention. The protection scope of the present invention shall be subject to the protection scope of the claims.

## Claims

1. A handset, comprising a housing (220), a card tray (241), the card tray (241) is configured to be inserted to or detached from the handset, wherein a pinhole (270) is disposed on the housing, the card tray (241) is detached from the handset after an ejector pin (260) passes through the pinhole (270) and a sealing kit (210) and a force is applied on the ejector pin (260);
the sealing kit (210) is inside the handset; an opening is disposed on the sealing kit (210);
when the ejector pin (260) passes through the sealing kit (210) after passing through the pinhole (270), the opening on the sealing kit (210) is opened; and when the ejector pin (260) is unplugged from the sealing kit (210), the opening on the sealing kit (210) is closed for water proofing.

2. The handset according to claim 1, wherein the sealing kit (210) is disposed at the pinhole.

3. The handset according to any one of claims 1 to 2, wherein the opening is located on a position corresponding to the pinhole's position.

4. The handset according to any one of claims 1 to 2, wherein the opening is located on a position corresponding to the middle of the pinhole.

5. The handset according to any one of claims 1 to 4, wherein the sealing kit (210) is a rubber pad (211).

6. The handset according to claim 5, wherein the rubber pad (211) is pasted on an inner side of the housing (220).

7. The handset according to any one of claims 1 to 6, wherein the opening disposed on the sealing kit is one of a cross-shaped gap, a line-shaped gap, or a gap in a shape of " 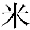 ".

8. The handset according to any one of claims 1 to 7, wherein the housing is a front housing (250).

9. The handset according to any one of claims 1 to 7, wherein the housing is a rear housing (220).

10. The handset according to any one of claims 1 to 7, wherein the housing comprises a frame, the pinhole is located on the frame.

## Patentansprüche

1. Handapparat, umfassend ein Gehäuse (220), ein Kartenfach (241), wobei das Kartenfach (241) dazu konfiguriert ist, in den Handapparat eingeführt oder davon getrennt zu werden, wobei ein kleines Loch (270) an dem Gehäuse angeordnet ist, das Kartenfach (241) von dem Handapparat getrennt wird, nachdem ein Auswerfstift (260) durch das kleine Loch (270) und eine Abdichtungsausrüstung (210) passiert und an den Auswerfstift (260) eine Kraft angelegt ist;
die Abdichtungsausrüstung (210) sich innerhalb des Handapparats befindet; eine Öffnung an der Abdichtungsausrüstung (210) angeordnet ist;
wenn der Auswerfstift (260) nach Passieren durch das kleine Loch (270) durch die Abdichtungsausrüstung (210) passiert, die Öffnung an der Abdichtungsausrüstung (210) geöffnet wird; und wenn der Auswerfstift (260) aus der Abdichtungsausrüstung (210) gezogen wird, die Öffnung an der Abdichtungsausrüstung (210) für Abdichtung gegen Wasser geschlossen wird.

2. Handapparat nach Anspruch 1, wobei die Abdichtungsausrüstung (210) an dem kleinen Loch angeordnet ist.

3. Handapparat nach einem der Ansprüche 1 bis 2, wobei sich die Öffnung an einer der der Stelle des kleinen Lochs entsprechenden Stelle befindet.

4. Handapparat nach einem der Ansprüche 1 bis 2, wobei sich die Öffnung an einer der Mitte des kleinen Lochs entsprechenden Stelle befindet.

5. Handapparat nach einem der Ansprüche 1 bis 4, wobei die Abdichtungsausrüstung (210) eine Gummiauflage (211) ist.

6. Handapparat nach Anspruch 5, wobei die Gummiauflage (211) an einer Innenseite des Gehäuses (220) geklebt ist.

7. Handapparat nach einem der Ansprüche 1 bis 6, wobei die an der Abdichtungsausrüstung angeordnete Öffnung eines von einem kreuzförmigen Spalt, einem linienförmigen Spalt oder einem Spalt in Form eines " 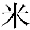 " ist.

8. Handapparat nach einem der Ansprüche 1 bis 7, wobei das Gehäuse ein vorderes Gehäuse (250) ist.

9. Handapparat nach einem der Ansprüche 1 bis 7, wobei das Gehäuse ein hinteres Gehäuse (220) ist.

10. Handapparat nach einem der Ansprüche 1 bis 7, wobei das Gehäuse einen Rahmen umfasst, und sich das kleine Loch an dem Rahmen befindet.

## Revendications

1. Téléphone mobile, comprenant un boîtier (220), un plateau de carte (241), le plateau de carte (241) est configuré pour être inséré dans le téléphone mobile ou détaché de celui-ci, dans lequel un trou d'épingle (270) est prévu sur le boîtier, le plateau de carte (241) est détaché du téléphone mobile après l'insertion d'une épingle d'éjection (260) à travers le trou d'épingle (270) et un kit d'étanchéité (210) et l'application d'une force à l'épingle d'éjection (260) ;
le kit d'étanchéité (210) est à l'intérieur du téléphone mobile ; une ouverture est disposée sur le kit d'étanchéité (210) ;
quand l'épingle d'éjection (260) est insérée à travers le kit d'étanchéité (210) après avoir été insérée à travers le trou d'épingle (270), l'ouverture sur le kit d'étanchéité (210) est ouverte ; et quand l'épingle d'éjection (260) est ressortie du kit d'étanchéité (210), l'ouverture sur le kit d'étanchéité (210) est refermée pour assurer l'étanchéité à l'eau.

2. Téléphone mobile selon la revendication 1, dans lequel le kit d'étanchéité (210) est disposé au niveau du trou d'épingle.

3. Téléphone mobile selon l'une quelconque des revendications 1 et 2, dans lequel l'ouverture est située à une position correspondant à la position du trou d'épingle.

4. Téléphone mobile selon l'une quelconque des revendications 1 et 2, dans lequel l'ouverture est située à une position correspondant au centre du trou d'épingle.

5. Téléphone mobile selon l'une quelconque des revendications 1 à 4, dans lequel le kit d'étanchéité (210) est une pastille en caoutchouc (211).

6. Téléphone mobile selon la revendication 5, dans lequel la pastille en caoutchouc (211) est appliquée sur un côté intérieur du boîtier (220).

7. Téléphone mobile selon l'une quelconque des revendications 1 à 6, dans lequel l'ouverture disposée sur le kit d'étanchéité est l'une parmi une ouverture en forme d'espace cruciforme, d'espace linéaire, ou d'espace en forme de « 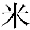 ».

8. Téléphone mobile selon l'une quelconque des revendications 1 à 7, dans lequel le boîtier est un boîtier avant (250).

9. Téléphone mobile selon l'une quelconque des revendications 1 à 7, dans lequel le boîtier est un boîtier arrière (220).

10. Téléphone mobile selon l'une quelconque des revendications 1 à 7, dans lequel le boîtier comprend un cadre, le trou d'épingle est situé sur le cadre.
